(19) Europäisches Patentamt
European Patent Office
Office européen des brevets

(11) EP 4 248 604 B1

(12) EUROPEAN PATENT SPECIFICATION

(45) Date of publication and mention of the grant of the patent:
**11.09.2024 Bulletin 2024/37**

(21) Application number: **20855832.0**

(22) Date of filing: **07.12.2020**

(51) International Patent Classification (IPC):
**H04L 27/26** (2006.01)   **H04L 27/38** (2006.01)
**H04L 27/36** (2006.01)   **H04L 25/03** (2006.01)
**H04B 17/21** (2015.01)   **H04B 17/14** (2015.01)
**H04L 5/14** (2006.01)    **H03F 1/32** (2006.01)
**H03F 3/24** (2006.01)    **H03F 3/19** (2006.01)

(52) Cooperative Patent Classification (CPC):
**H04L 27/3863; H03F 1/3247; H03F 3/19;**
**H03F 3/24; H04B 17/14; H04L 5/1469;**
**H04L 25/03343; H04L 27/368;** H03F 2200/336;
H03F 2200/451; H04L 27/261

(86) International application number:
**PCT/RU2020/000664**

(87) International publication number:
**WO 2022/124920 (16.06.2022 Gazette 2022/24)**

(54) **METHOD FOR IN-PHASE AND QUADRATURE IMBALANCE ESTIMATION AND COMMUNICATION APPARATUS**

VERFAHREN ZUR PHASENGLEICHEN UND QUADRATURUNGLEICHGEWICHTSSCHÄTZUNG UND KOMMUNIKATIONSVORRICHTUNG

PROCÉDÉ D'ESTIMATION DE DÉSÉQUILIBRE EN PHASE ET EN QUADRATURE ET APPAREIL DE COMMUNICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.09.2023 Bulletin 2023/39**

(73) Proprietor: **Huawei Technologies Co., Ltd.**
**Shenzhen, Guangdong 518129 (CN)**

(72) Inventors:
- **TAFINTSEV, Konstantin Stanislavovich**
  **Shenzhen Guangdong, 518129 (CN)**
- **LARIONOV, Alexander Borisovich**
  **Shenzhen Guangdong, 518129 (CN)**
- **SHEVCHENKO, Igor Vsevolodovich**
  **Shenzhen Guangdong, 518129 (CN)**
- **KUKLEV, Konstantin Igorevich**
  **Shenzhen Guangdong, 518129 (CN)**
- **MESHCHERYAKOV, Alexey Vyacheslavovich**
  **Shenzhen Guangdong, 518129 (CN)**

(74) Representative: **Thun, Clemens**
**Mitscherlich PartmbB**
**Patent- und Rechtsanwälte**
**Karlstraße 7**
**80333 München (DE)**

(56) References cited:
**US-A1- 2012 300 818    US-A1- 2016 359 614**

- **SADJINA SILVESTER ET AL: "A Mixed-Signal Circuit Technique for Cancellation of Interferers Modulated by LO Phase-Noise in 4G/5G CA Transceivers", IEEE TRANSACTIONS ON CIRCUITS AND SYSTEMS I: REGULAR PAPERS, IEEE, US, vol. 65, no. 11, 1 November 2018 (2018-11-01), pages 3745 - 3755, XP011691082, ISSN: 1549-8328, [retrieved on 20181005], DOI: 10.1109/TCSI.2018.2861460**

**Description**

**TECHNICAL FIELD**

The present disclosure relates generally to the field of signal processing, and particularly to a method for In-phase and Quadrature (I/Q) imbalance estimation and compensation, as well as to a corresponding communication apparatus.

**BACKGROUND**

Direct conversion transceivers have the advantage over intermediate frequency transceivers that they have a simplified hardware configuration, are less cost- and power-consuming, and may be implemented in integrated circuits. However, one of the main disadvantages of the direct conversion transceivers is an I/Q imbalance which significantly deteriorates their characteristics. The occurrence of the I/Q-imbalance in the direct conversion transceivers is associated, for example, with the use of analog up/down-converters and low-pass filters. In addition, for broadband devices, it is necessary to take into account the frequency dependence of the I/Q imbalance in a signal modulation band.

The existing methods for I/Q imbalance estimation and compensation rely on using additional external hardware (e.g., such as an envelope detector) that is often unavailable for regular data transmission. Moreover, the existing methods usually involve performing the I/Q estimation and compensation in two steps: for a transmitter path first and then for a receiver path. Therefore, it takes relatively long time to calibrate the direct conversion transceivers before their normal use.

For example, US 2016/359614 A1 refers to systems and techniques relating to calibrating I/Q mismatches in communication systems. In some implementations, a reference signal to be transmitted by a transmitter (Tx) is identified. A loopback signal corresponding to the reference signal is generated by passing the reference signal through the TX and a receiver (Rx). The loopback signal includes an additional signal that distinguishes an in-phase/quadrature (I/Q) mismatch caused by the Tx (Tx I/Q mismatch) from an I/Q mismatch caused by the Rx (RX I/Q mismatch). A set of Tx I/Q mismatch parameters and a set of Rx I/Q mismatch parameters are determined based on the reference signal and the loopback signal, using the additional signal. A Tx signal is calibrated based on the set of Tx I/Q mismatch parameters, while a Rx signal is calibrated based on the set of Rx I/Q mismatch parameters, independently from the calibrating the Tx signal.

**SUMMARY**

This summary is provided to introduce a selection of concepts in a simplified form that are further described below in the detailed description. This summary is not intended to identify key features of the present disclosure, nor is it intended to be used to limit the scope of the present disclosure.

It is an objective of the present disclosure to provide a solution that enables I/Q estimation and compensation in a communication apparatus (especially, a direct conversion transceiver).

The objective is achieved by the features of the independent claims in the appended claims. Further embodiments and examples are apparent from the dependent claims, the detailed description, and the accompanying drawings.

According to a first aspect, a communication apparatus is provided. The communication apparatus comprises a transmitter (TX), a receiver (RX), a phase-locked loop (PLL), and a RF loopback path. The PLL is configured to generate a TX local oscillator (LO) signal and a RX LO signal, and to successively provide a first phase shift and a different second phase shift between the TX LO signal and the RX LO signal. The TX is configured to generate a reference signal and to obtain a TX RF signal by quadrature mixing of the reference signal with the TX LO signal. The RF loopback path is configured to output the TX RF signal to the RX as a RX RF signal. The RX is configured to obtain a representation of the reference signal by quadrature mixing of the RX RF signal with the RX LO signal. The TX comprises an adaptive filter configured to:

based on the reference signal and the representation of the reference signal in case of the first phase shift between the TX LO signal and the RX LO signal, obtain a first estimate of a combined TX/RX frequency-dependent I/Q imbalance in a time domain;

based on the reference signal and the representation of the reference signal in case of the second phase shift between the TX LO signal and the RX LO signal, obtain a second estimate of the combined TX/RX frequency-dependent I/Q imbalance in the time domain; and based on the first and second estimates, determine a contribution made by each of the TX and the RX in the combined TX/RX frequency-dependent I/Q imbalance in the time domain.

With this configuration, the communication apparatus may estimate the combined TX/RX frequency-dependent I/Q imbalance without having to use additional external hardware (e.g., such as an envelope detector). The knowledge of the contributions made by the TX and the RX in the combined TX/RX frequency-dependent I/Q imbalance may be then used to compensate the combined TX/RX frequency-dependent I/Q imbalance itself in the time domain.

In one embodiment of the first aspect, the TX is configured to generate the reference signal as a pseudo-noise signal or an Orthogonal Frequency-Division Multiplexing (OFDM) signal. By so doing, it is possible to study the combined TX/RX frequency-dependent I/Q imbalance in a wideband of the communication apparatus more efficiently. Furthermore, the OFDM signal is a signal used for regular data transmission in a wireless communication system, thereby meaning that the apparatus according to the first aspect does not need to generate any special signal for the purpose of the I/Q imbalance estimation and compensation in the time domain.

In one embodiment of the first aspect, the adaptive filter is configured to obtain the first estimate of the combined TX/RX frequency-dependent I/Q imbalance and the second estimate of the combined TX/RX frequency-dependent I/Q imbalance by using one of a Least-Mean-Square (LMS) algorithm, a normalized LMS algorithm, a leaky LMS algorithm, and a recursive least squares algorithm. This may make the apparatus according to the first aspect more flexible in use because it may decide on one of these several algorithms depending on particular application.

In one embodiment of the first aspect, the second phase shift differs from the first phase shift by 90 degrees. This preferred phase shift provides the highest accuracy of the I/Q imbalance estimation and compensation.

In one embodiment of the first aspect, the TX further comprises a pre-compensating finite impulse response (FIR) filter configured to compensate the determined contribution made by the TX in the combined TX/RX frequency-dependent I/Q imbalance, and the RX comprises a post-compensating FIR filter configured to compensate the determined contribution made by the RX in the combined TX/RX frequency-dependent I/Q imbalance. By using such FIR filters, the compensation of the contributions made by each of the TX and the RX in the combined TX/RX frequency-dependent I/Q imbalance may be performed more efficiently.

In one embodiment of the first aspect, each of the pre-compensating FIR filter and the post-compensating FIR filter has a filter length predefined based on a required accuracy of I/Q imbalance contribution compensation and/or a required amount of computational resources to be used for the I/Q imbalance contribution compensation. This may provide an acceptable tradeoff between the accuracy of I/Q imbalance contribution compensation and the computational resources used therefor.

In one embodiment of the first aspect, the pre-compensating FIR filter and the post-compensating FIR filter are configured to simultaneously compensate the determined contributions made by the TX and the RX, respectively, in the combined TX/RX frequency-dependent I/Q imbalance. By so doing, it is possible to reduce the time and number of measurements and calculations which are required for the I/Q imbalance compensation in the apparatus according to the first aspect.

In one embodiment of the first aspect, the pre-compensating FIR filter and the post-compensating FIR filter are configured to compensate the determined contributions made by the TX and the RX, respectively, in the combined TX/RX frequency-dependent I/Q imbalance when the communication apparatus operates in a time division duplexing (TDD) mode. This may make the apparatus according to the first aspect more flexible in use. In particular, the fact that the apparatus according to the first aspect may perform the I/Q imbalance estimation and compensation in the TDD mode means that it may do the same in a frequency division duplexing (FDD) mode. It should be noted that the opposite is not true, i.e. the possibility of the I/Q imbalance estimation and compensation in the FDD mode does not mean the possibility of doing the same in the TDD mode.

In one embodiment of the first aspect, the TX further comprises a nonlinear power amplifier configured to amplify the TX RF signal. In this embodiment, the apparatus according to the first aspect further comprises a digital signal processing unit configured to reduce nonlinear distortions occurring in the amplified TX RF signal by using a digital pre-distortion algorithm. By using the I/Q imbalance estimation and compensation in conjunction with the DPD algorithm, it is possible to improve the performance of the apparatus according to the first aspect.

According to a second aspect, a method for I/Q imbalance estimation in a communication apparatus is provided. The communication apparatus comprises a TX, a RX, a PLL, and a RF loopback path connecting the TX and the RX. The method comprises the following steps:

(a) generating, by the TX, a reference signal;

(b) generating, by the PLL, a TX LO signal and a RX LO signal;

(c) obtaining, by the TX, a TX RF signal by quadrature mixing of the reference signal with the TX LO signal;

(d) outputting the TX RF signal to the RX as a RX RF signal through the RF loopback path; and

(e) obtaining, by the RX, a representation of the reference signal by quadrature mixing the RX RF signal with the RX LO signal.

According to the method, steps (a)-(e) are performed successively at a first phase shift and a different second phase shift between the TX LO signal and the RX LO signal. The method further comprises the steps of:

(f) based on the reference signal and the representation of the reference signal in case of the first phase shift between the TX LO signal and the RX LO signal, obtaining a first estimate of a combined TX/RX frequency-dependent I/Q imbalance in a time domain;

(g) based on the reference signal and the representation of the reference signal in case of the second phase shift between the TX LO signal and the RX LO signal, obtaining a second estimate of the combined TX/RX frequency-dependent I/Q imbalance in the time domain; and

(h) based on the first and second estimates, determining a contribution made by each of the TX and the RX in the combined TX/RX frequency-dependent I/Q imbalance in the time domain.

By so doing, it is possible to estimate and compensate the combined TX/RX frequency-dependent I/Q imbalance in the communication apparatus without having to use additional external hardware (e.g., such as an envelope detector).

In one embodiment of the second aspect, step (a) comprises generating the reference signal as a pseudo-noise signal or an OFDM signal. By so doing, it is possible to study the combined TX/RX frequency-dependent I/Q imbalance in a wideband of the communication apparatus more efficiently. Furthermore, the OFDM signal is a signal used for regular data transmission in a wireless communication system, thereby meaning that the communication apparatus does not need to generate any special signal for the purpose of the I/Q imbalance estimation and compensation in the time domain.

In one embodiment of the second aspect, steps (f) and (g) are performed by using one of a Least-Mean-Square (LMS) algorithm, a normalized LMS algorithm, a leaky LMS algorithm, and a recursive least squares algorithm. This may make the method according to the second aspect more flexible in use because it may use one of these several algorithms depending on particular application.

In one embodiment of the second aspect, the second phase shift differs from the first phase shift by 90 degrees. This preferred phase shift provides the highest accuracy of the I/Q imbalance estimation and compensation.

In one embodiment of the second aspect, the method further comprises the step of compensating the determined contribution made by each of the TX and the RX in the combined TX/RX frequency-dependent I/Q imbalance using a pre-compensating FIR filter in the TX and a post-compensating FIR filter in the RX. Each of the pre-compensating FIR filter and the post-compensating FIR filter has a filter length predefined based on a required accuracy of I/Q imbalance contribution compensation and/or a required amount of computational resources to be used for the I/Q imbalance contribution compensation. By using such FIR filters, the compensation of the contributions made by each of the TX and the RX in the combined TX/RX frequency-dependent I/Q imbalance may be performed more efficiently. Furthermore, by selecting the filter length in this manner, it is possible to provide an acceptable tradeoff between the accuracy of I/Q imbalance contribution compensation and the computational resources used therefor.

In one embodiment of the second aspect, the determined contributions made by the TX and the RX in the combined TX/RX frequency-dependent I/Q imbalance are compensated simultaneously. By so doing, it is possible to reduce the time and number of measurements and calculations which are required for the I/Q imbalance compensation in the communication apparatus.

In one embodiment of the second aspect, the determined contributions made by the TX and the RX in the combined TX/RX frequency-dependent I/Q imbalance are compensated when the communication apparatus operates in a TDD mode. This may make the method according to the second aspect more flexible in use. In particular, the fact that the method according to the second aspect may be used to perform the I/Q imbalance estimation and compensation in the TDD mode means that it may be used for the same purpose in an FDD mode. It should be noted that the opposite is not true, i.e. the possibility of the I/Q imbalance estimation and compensation in the FDD mode does mean the possibility of doing the same in the TDD mode.

In one embodiment of the second aspect, the method further comprises the steps of amplifying the TX RF signal by using a nonlinear power amplifier in the TX, and reducing nonlinear distortions occurring in the amplified TX RF signal by using a DPD algorithm. By using the I/Q imbalance estimation and compensation in conjunction with the DPD algorithm, it is possible to improve the performance of the method according to the second aspect.

According to a third aspect, a computer program product is provided. The computer program product comprises a computer-readable storage medium storing a computer code. When executed by at least one processor of a communication apparatus, the computer code causes the communication apparatus to perform the method according to the second aspect. By using such a computer program product, it is possible to simplify the implementation of the method according to the second aspect in any computing device.

Other features and advantages of the present disclosure will be apparent upon reading the following detailed description and reviewing the accompanying drawings.

## BRIEF DESCRIPTION OF THE DRAWINGS

The present disclosure is explained below with reference to the accompanying drawings in which:

FIG. 1 shows a schematic block diagram of a communication apparatus 100 in accordance with one exemplary embodiment;

FIG. 2 shows a flowchart of a method for In-phase and Quadrature (I/Q) imbalance estimation in accordance with one exemplary embodiment;

FIG. 3 shows topologies of a transmitter (TX) and a receiver (RX) included in the communication apparatus shown in FIG. 1 in accordance with one exemplary embodiment;

FIG. 4 shows a flowchart explaining how the I/Q imbalance estimation and compensation may be used in concert with a digital pre-distortion (DPD) algorithm in the method shown in FIG. 2 in accordance with one exemplary embodiment;

FIG. 5 shows dependencies of an error value magnitude (EVM) on an average output power of a nonlinear power amplifier included in the TX, which are obtained on a test platform using the method shown in FIG. 2 in view of the flowchart shown in FIG. 4; and

FIG. 6A and 6B show a power spectral density of a residual I/Q imbalance signal at the output of the TX and the RX, respectively, which is resulted from the use of the method shown in FIG. 2 without considering the nonlinearity of the power amplifier.

## DETAILED DESCRIPTION

Various embodiments of the present disclosure are further described in more detail with reference to the accompanying drawings. However, the present disclosure may be embodied in many other forms and should not be construed as limited to any certain structure or function discussed in the following description. In contrast, these embodiments are provided to make the description of the present disclosure detailed and complete. The present invention is defined by the scope of the appended claims.

According to the detailed description, it will be apparent to the ones skilled in the art that the scope of the present disclosure encompasses any embodiment thereof, which is disclosed herein, irrespective of whether this embodiment is implemented independently or in concert with any other embodiment of the present disclosure. For example, the apparatus and method disclosed herein may be implemented in practice by using any numbers of the embodiments provided herein. Furthermore, it should be understood that any embodiment of the present disclosure may be implemented using one or more of the features presented in the appended claims.

The word "exemplary" is used herein in the meaning of "used as an illustration". Unless otherwise stated, any embodiment described herein as "exemplary" should not be construed as preferable or having an advantage over other embodiments.

As used in the embodiments disclosed herein, a communication apparatus may refer to a transceiving apparatus configured to employ two parallel channels I (in-phase) and Q (quadrature) to perform complex signal processing. For example, the I/Q channels may be used to perform a quadrature modulation/demodulation function. Non-restrictive examples of such a communication apparatus include a direct conversion transceiver, a low intermediate frequency (low-IF) transceiver, etc. Moreover, such a communication apparatus may be implemented as part of a user equipment (UE) or a network node.

The UE may refer to a mobile device, a mobile station, a terminal, a subscriber unit, a mobile phone, a cellular phone, a smart phone, a cordless phone, a personal digital assistant (PDA), a wireless communication device, a desktop computer, a laptop computer, a tablet computer, a gaming device, a netbook, a smartbook, an ultrabook, a medical device or medical equipment, a biometric sensor, a wearable device (for example, a smart watch, smart glasses, a smart wrist band, etc.), an entertainment device (for example, an audio player, a video player, etc.), a vehicular component or sensor, a smart meter/sensor, an unmanned vehicle (e.g., an industrial robot, a quadcopter, etc.), industrial manufacturing equipment, a global positioning system (GPS) device, an Internet-of-Things (IoT) device, an Industrial IoT (IIoT) device, a machine-type communication (MTC) device, a group of Massive IoT (MIoT) or Massive MTC (mMTC) devices/sensors, or any other suitable device configured to support wireless communications. In some embodiments, the UE may refer to at least two collocated and inter-connected UEs thus defined.

The network node may relate to a fixed point of communication for the UE in a particular wireless or wired communication network. In case of a wireless communication network, the network node may implemented as a Radio Access Network (RAN) node referred to as a base transceiver station (BTS) in terms of the 2G communication technology, a NodeB in terms of the 3G communication technology, an evolved NodeB (eNodeB) in terms of the 4G communication technology, and a gNB in terms of the 5G New Radio (NR) communication technology. The RAN node may serve different cells, such as a macrocell, a microcell, a picocell, a femtocell, and/or other types of cells. The macrocell may cover a relatively large geographic area (for example, at least several kilometers in radius). The microcell may cover a geographic area less than two kilometers in radius, for example. The picocell may cover a relatively small geographic area, such, for example, as offices, shopping malls, train stations, stock exchanges, etc. The femtocell may cover an even smaller geographic area (for example, a home). Correspondingly, the RAN node serving the macrocell may be referred to as a macro node, the RAN node serving the microcell may be referred to as a micro node, and so on.

According to the embodiments disclosed herein, an I/Q imbalance may refer to an interference between an I (in-phase) channel and a Q (quadrature) channel in the communication apparatus, which is caused by gain imbalance between the I channel and the Q channel and by a quadrature error between the I channel and the Q channel. The I/Q imbalance occurs particularly frequently when a high frequency, such as a frequency in the millimeter band, is used for communication, when a broadband signal is handled, or when inexpensive (low-quality) components are employed in the communication apparatus.

Many studies have been focused on improving I/Q imbalance estimation and compensation. However, most of them are devoted to the I/Q imbalance estimation and compensation in a receiver (RX) path, and much less in a transmitter (TX) path. Furthermore, it is usually recommended to use external hardware, such as an envelope detector, to estimate the I/Q imbalance. In case of the frequency-dependent I/Q imbalance, it is additionally recommended to estimate it by using either multi-tones or OFDM pilot signals as a reference signal. In this case, the I/Q imbalance in a frequency domain (at individual frequencies) is estimated. This approach is poorly compatible, for example, with a digital pre-distortion (DPD) algorithm which is performed in a time domain to improve the linearity of power amplifiers.

There are also methods for I/Q imbalance estimation and compensation by using an OFDM signal in a time division duplexing (TDD) mode. However, these existing methods are mainly performed in two steps. There are various ways in which, as a rule, the TX path is estimated and calibrated first. And then, after the I/Q imbalance in the TX path is compensated, the I/Q imbalance in the RX path is estimated and compensated. Moreover, these existing methods also use additional external hardware, such as the envelope detector, which is unavailable for regular data transmission in a wireless communication system.

A very limited number of works is associated with simultaneous TX/RX calibration (in terms of the I/Q imbalance estimation and compensation) according to a loopback transceiver. However, most of them, which involve simultaneously estimating and compensating the TX and RX I/Q imbalance in the loopback transceiver, are related to frequency division duplexing (FDD) communication systems where there is a frequency offset between the TX path and the RX path. Thus, using such methods for TDD communication systems also requires using an additional external hardware, such as an external down-converter.

The exemplary embodiments disclosed herein provide a technical solution that allows mitigating or even eliminating the above-sounded drawbacks peculiar to the prior art. In particular, the technical solution disclosed herein involves using an adaptive filter in a loopback architecture of a communication apparatus to estimate and compensate a combined TX/RX frequency-dependent I/Q imbalance. The combined TX/RX frequency-dependent I/Q imbalance is estimated by using a reference signal and two different phase shifts between a TX local oscillator (LO) signal and a RX LO signal. The resulting two estimates of the combined TX/RX frequency-dependent I/Q imbalance are further used to calculate separately contributions made by a TX and a RX in the combined TX/RX frequency-dependent I/Q imbalance. By so doing, it is possible to estimate the combined TX/RX frequency-dependent I/Q imbalance without having to use additional external hardware. The calculated contributions may be then used to compensate the combined TX/RX frequency-dependent I/Q imbalance itself in a time domain.

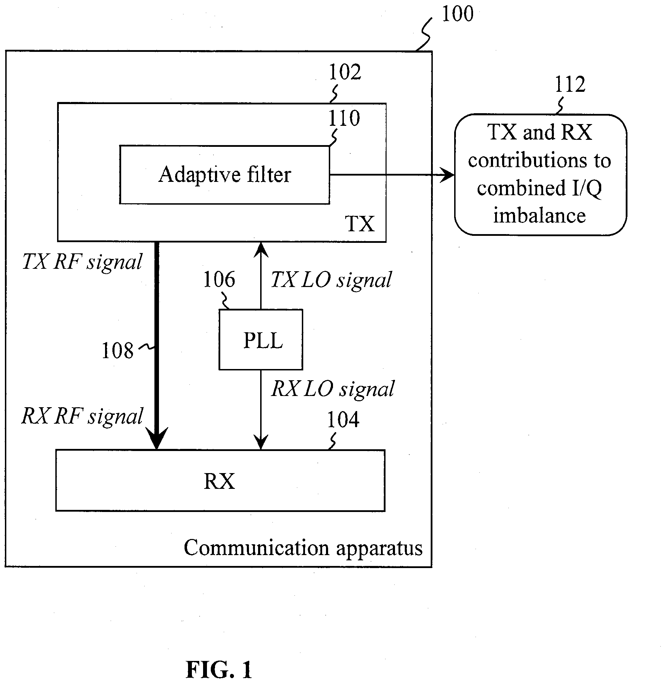

FIG. 1 shows a schematic block diagram of a communication apparatus 100 in accordance with one exemplary embodiment. The communication apparatus 100 may be implemented as part of a UE or a network node, as discussed above. As shown in FIG. 1, the communication apparatus 100 comprises a transmitter (TX) 102, a receiver (RX) 104, a phase-locked loop (PLL) 106, and a RF loopback path 108. It is assumed that each of the TX 102 and the RX 104 comprises an I (in-phase) channel and a Q (quadrature) channel. It is further assumed that there is a combined TX/RX frequency-dependent I/Q imbalance caused, for example, by a digital-to-analog converter (DAC), a low-pass filter (LPF) and an up-converter included in the I and Q channels of the TX 102 and by an analog-to-digital converter (ADC), an LPF and a down-converter included in the I and Q channels of the RX 104. As also shown in FIG. 1, the TX 102 comprises an adaptive filter 110 configured to determine contributions 112 made by each of the TX 102 and the RX 104 in the combined TX/RX frequency-dependent I/Q imbalance in the time domain, as will be discussed further in more detail. It should be noted that the RF loopback path 108 is used in the communication apparatus 100 only for the purpose of estimating and compensating the contributions 112, which means that the RF loopback path 108 may be excluded from the communication apparatus 100 after the estimating and compensating procedure is completed. Furthermore, the number, arrangement and interconnection of the constructive elements constituting the communication apparatus 100, which are shown in FIG. 1, are not intended to be any limitation of the present disclosure, but merely used to provide a general idea of how the constructive elements may be implemented within the communication apparatus 100. It should be also noted that the PLL 106, the RF loopback path 108, the adaptive filter 110 and typical different elements of the TX 102 and the RX 104, for example, such as the DAC/ADC, the LPF, the up-/down-converters, are well-known in the art, for which reason their detailed description is omitted herein.

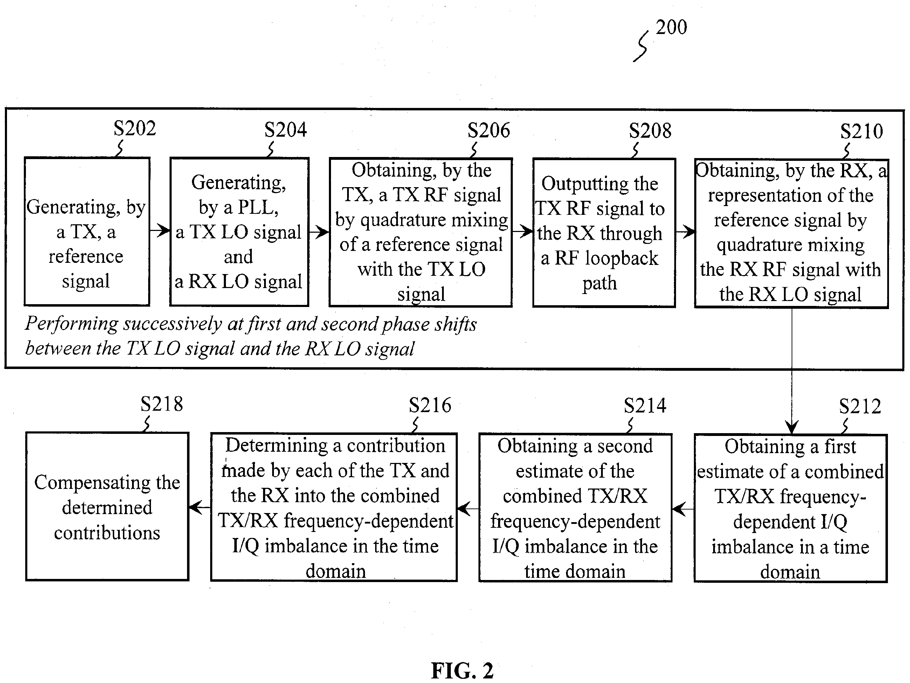

FIG. 2 shows a flowchart of a method 200 for I/Q imbalance estimation in accordance with one exemplary embodiment. The method 200 as such describes the calibration of the communication apparatus 100, which is aimed at estimating and compensating the contributions 112 made by the TX 102 and the RX 104 in the combined TX/RX frequency-dependent I/Q imbalance. As shown in FIG. 2, the method 200 starts with a step S202, in which the TX 102 generates a reference signal. In some embodiments, the step 5202 may involve generating the reference signal as a pseudo-noise signal or an Orthogonal Frequency-Division Multiplexing (OFDM) signal. After or in parallel to the step S202, the PLL 106 generates a TX LO signal for the TX 102 and a RX LO signal for the RX 104 in a step S204 of the method 200. Next, the method 200 proceeds to a step S206, in which the TX 102 obtains a TX RF signal by quadrature mixing of the reference signal with the TX LO signal. Further, the method 200 goes on to a step S208, in which the TX RF signal is propagated towards the RX 104 through the RF loopback path 108. It should be noted that the TX RF signal is outputted from the RF loopback path 108 as a RX RF signal. The RX RF signal is then used in a step S210, in which the RX 104 obtains a representation of the reference signal by quadrature mixing the RX RF signal with the RX LO signal. The representation of the reference signal comprises the reference signal itself plus a noise component caused by the combined TX/RX frequency-dependent I/Q imbalance. According to the method 200, the steps S202-S210 are performed successively at a first phase shift and a different second phase shift between the TX LO signal and the RX LO signal. In a preferred embodiment, the second phase shift differs from the first phase shift by 90 degrees; this phase difference value the highest accuracy of the I/Q imbalance estimation and compensation in accordance with the method 200.

Once the steps 5202-5210 are repeated for the two different phase measurements, the method 200 goes on. In particular, it proceeds to a step S212, in which the adaptive filter 110 obtains a first estimate of the combined TX/RX frequency-dependent I/Q imbalance in the time domain based on the reference signal and the representation of the reference signal in case of the first phase shift between the TX LO signal and the RX LO signal. Then, in a step S214, the adaptive filter 110 obtains a second estimate of the combined TX/RX frequency-dependent I/Q imbalance in the time domain based on the reference signal and the representation of the reference signal in case of the second phase shift between the TX LO signal and the RX LO signal. It should be noted that the steps S212 and 5214 may be implemented by the adaptive filter 110 in parallel, if required. Further, in a step S216, in which the adaptive filter 110 uses the first and second estimates to determine the contributions 112 made by the TX 102 and the RX 104 in the combined TX/RX frequency-dependent I/Q imbalance in the time domain. The method 200 may end up in a step S218, in which the determined contributions are compensated. By using the method 200, it is possible to estimate and compensate the combined TX/RX frequency-dependent I/Q imbalance in the communication apparatus 100 without having to use additional external hardware (e.g., such as the envelope detector).

In one exemplary embodiment, the steps S212 and 5214 of the method 200 are performed by using one of a Least-Mean-Square (LMS) algorithm, a normalized LMS algorithm, a leaky LMS algorithm, and a recursive least squares algorithm. Each of these several algorithms may be used depending on particular application.

In one exemplary embodiment, the step 218 of the method 200 is performed by using a pre-compensating FIR filter in the TX 102 and a post-compensating FIR filter in the RX 104. In this case, the term "pre-compensating" means that the corresponding filter is located before an I/Q imbalance source (e.g., before the DAC and the up-converter) in the TX 102, while the term "post-compensating" means that the corresponding filter is located after an I/Q imbalance source (e.g., after the down-converter and the ADC) in the RX 104. Each of the pre-compensating FIR filter and the post-compensating FIR filter has its own filter length predefined based on a required accuracy of I/Q imbalance contribution compensation and/or a required amount of computational resources to be used for the I/Q imbalance contribution compensation. By using such FIR filters, the compensation of the contributions made by each of the TX 102 and the RX 104 in the combined TX/RX frequency-dependent I/Q imbalance may be performed more efficiently. Furthermore, by selecting the filter length in this manner, it is possible to provide an acceptable tradeoff between the accuracy of I/Q imbalance contribution compensation and the computational resources used therefor.

In one exemplary embodiment, the determined contributions 112 made by the TX 102 and the RX 104 in the combined TX/RX frequency-dependent I/Q imbalance are compensated simultaneously in the step S218. By so doing, it is possible to reduce the time and number of measurements and calculations required for the I/Q imbalance compensation in the communication apparatus 100.

In one exemplary embodiment, the determined contributions 112 made by the TX 102 and the RX 104 in the combined TX/RX frequency-dependent I/Q imbalance are compensated in the step S218 when the communication apparatus 100 operates in a TDD mode. The possibility of using the method 200 in the TDD mode means that it may be also used in an FDD mode. It should be noted that the opposite is not true, i.e. the possibility of the I/Q imbalance estimation and compensation in the FDD mode does not mean the possibility of doing the same in the TDD mode. Therefore, the method 200 is more flexible in use compared to the existing methods for the I/Q imbalance estimation and compensation.

In one exemplary embodiment, when the communication apparatus 100 further comprises a nonlinear power amplifier in the TX 102 and a digital signal processing (DSP) unit, the method 200 comprises the following additional steps, in which the TX RF signal obtained in the step S206 is amplified by using the nonlinear power amplifier and nonlinear distortions occurring in the amplified TX RF signal are reduced by using a DPD algorithm executed by the DSP unit. By using the I/Q imbalance estimation and compensation in conjunction with the DPD algorithm, it is possible to improve the performance of the method 200. It should be also noted that the DSP unit may be implemented by using a CPU, general-purpose processor, single-purpose processor, microcontroller, microprocessor, application specific integrated circuit (ASIC), field programmable gate array (FPGA), digital signal processor (DSP), complex programmable logic device, etc. In some embodiments, the DSP unit may be implemented as any combination of the aforesaid, e.g., as two or more microprocessors.

Let us now consider how to calculate the contributions 112 made by the TX 102 and the RX 104 in the combined TX/RX frequency-dependent I/Q imbalance. For this purpose, let us assume that the adaptive filter 110 uses the LMS algorithm, and the DSP unit uses the DPD algorithm. The first estimate of the combined TX/RX frequency-dependent I/Q imbalance is performed with the first phase shift between the TX LO signal and the RX LO signal, for example, equal to zero. Let x be the reference signal, then an I/Q imbalance $\beta_{tx}$ in the TX 102 is defined by:

$$x - \beta_{tx} \cdot x^*,$$

where $x^*$ is the conjugate of x. An estimate $\beta_1$ of the combined TX/RX frequency-dependent I/Q imbalance, which is obtained by the adaptive filter 110 at the first phase shift, is equal to:

$$x + \beta_1 \cdot x^*.$$

Then, the TX RF signal after the I/Q imbalance source in the TX 102 is obtained as:

$$(x + \beta_1 \cdot x^*) - \beta_{tx} \cdot (x + \beta_1 \cdot x^*)^* \cong x + (\beta_1 - \beta_{tx}) \cdot x^*.$$

The output signal of the RF loopback path 108, i.e. the RX RF signal, is obtained as:

$$(x + (\beta_1 - \beta_{tx}) \cdot x^*) - \beta_{rx} \cdot (x + (\beta_1 - \beta_{tx}) \cdot x^*)^* \cong x + (\beta_1 - \beta_{tx} - \beta_{rx}) \cdot x^*,$$

where $\beta_{rx}$ is the I/Q imbalance in the RX 104. Therefore, the following expression should be executed in the I/Q imbalance compensation case:

$$\beta_1 - \beta_{tx} - \beta_{rx} = 0.$$

Then, the PLL 106 sets the second phase shift between the TX LO signal and the RX LO signal. In this case, the TX RF signal after the I/Q imbalance source in the TX 102 is obtained as:

$$\Phi \cdot x + \Phi \cdot (\beta_2 - \beta_{tx}) \cdot x^*,$$

where $\Phi = |\Phi| \cdot e^{j \cdot \varphi}$ is the transfer function of an RF phase shifter. As noted earlier, the PLL 106 sets the phase shift between the TX LO and RX LO signals, and this operation of the PLL 106 is equivalent to the operation of some RF phase shifter with the transfer function Φ.

Hence, the RX RF signal outputted from the RF loopback path 108 is obtained as:

$$y = \Phi \cdot x + \Phi \cdot (\beta_2 - \beta_{tx}) \cdot x^* - \beta_{rx} \cdot (\Phi \cdot x + \Phi \cdot (\beta_2 - \beta_{tx}) \cdot x^*)^*$$
$$\cong \Phi \cdot x + (\Phi \cdot (\beta_2 - \beta_{tx}) - \beta_{rx} \cdot \Phi^*) \cdot x^*$$

The output signal y should be aligned with the reference signal as follows:

$$y_{aligned} = G \cdot y = x + (\beta_2 - \beta_{tx} - \beta_{rx} \cdot e^{-j \cdot 2\varphi}) \cdot x^*,$$

where $G = \Phi^{-1}$; $\quad \Phi^{-1} = \dfrac{1}{|\Phi|} \cdot e^{-j \cdot \varphi} \quad$; $\Phi^* = |\Phi| \cdot e^{-j \cdot \varphi}$.

Therefore, the following expression should be executed in the I/Q imbalance compensation case at the second phase shift:

$$\beta_2 - \beta_{tx} - \beta_{rx} \cdot e^{-j \cdot 2\varphi} = 0.$$

As a result, one can obtain the following system equation:

$$\begin{cases} \beta_1 = \beta_{tx} + \beta_{rx} \\ \beta_2 = \beta_{tx} + \beta_{rx} \cdot e^{-j \cdot 2\varphi} \end{cases}$$

The results of these two measurements (i.e. at the first and second phase shifts between the TX LO signal and the RX LO signal) make it possible to calculate separately the contributions 112 made by the TX 102 and RX 104 in the combined TX/RX frequency-dependent I/Q imbalance, namely:

$$\begin{cases} \beta_{rx} = \dfrac{\beta_1 - \beta_2}{1 - e^{-j \cdot 2\varphi}} \\ \beta_{tx} = \dfrac{\beta_2 - \beta_1 \cdot e^{-j \cdot 2\varphi}}{1 - e^{-j \cdot 2\varphi}} \end{cases}$$

The following notes should be taken into consideration. Firstly, as noted earlier, the best calculation accuracy is ensured when the difference between the first and second phase shifts is 90 degrees. Secondly, in the presence of the nonlinear power amplifier, the level of I/Q imbalance compensation is limited by the level of nonlinear products after the DPD algorithm. On the other hand, the presence of the I/Q imbalance leads to additional nonlinear distortion products (due to the occurrence of complex conjugate components in the signal spectrum). Therefore, the simultaneous operation of the DPD algorithm and the compensation of I/Q imbalance is correct.

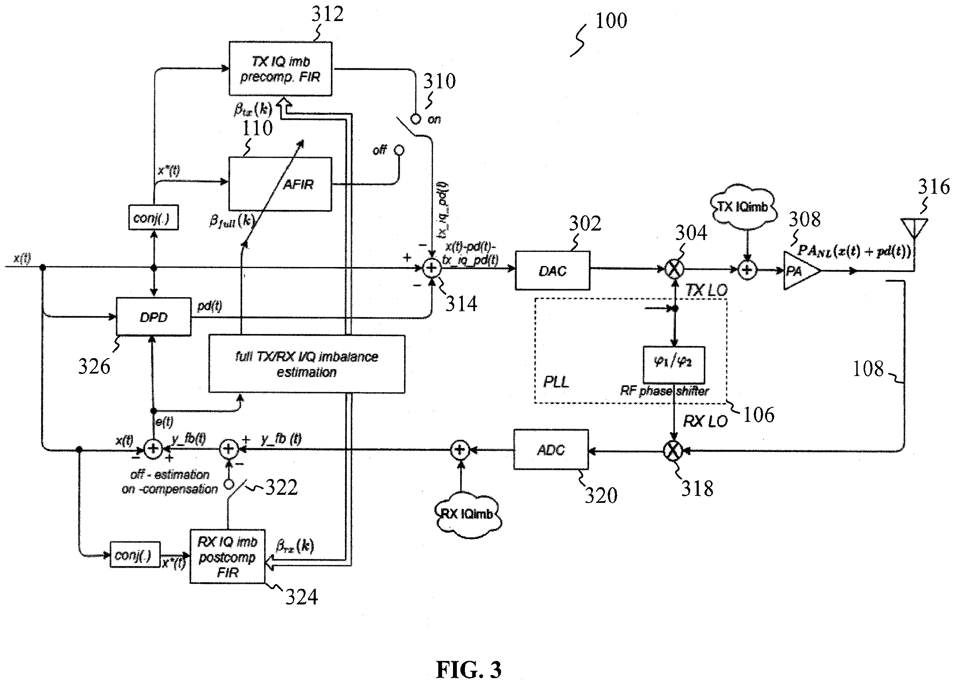

FIG. 3 shows topologies of the TX 102 and the RX 104 included in the communication apparatus 100 in accordance with one exemplary embodiment. As shown in FIG.3, the TX 102 of the communication apparatus 100 comprises a DAC 302, an up-converter 304, a nonlinear power amplifier 308, a switch 310, a pre-compensating FIR filter 312, an adder 314, an antenna 316, and the adaptive filter 110. The RX 104 of the communication apparatus 100 comprises a down-converter 318, an ADC 320, a switch 322, and a post-compensating FIR filter 324. The I/Q imbalance sources in the TX 102 and the RX 104 are schematically shown in FIG. 3 as "TX IQimb" and "RX IQimb", respectively. Moreover, as follows from FIG. 3, the communication apparatus 100 also comprises a DSP unit 326 configured to perform the DPD algorithm. The adaptive filter 110 is implemented as an adaptive FIR (AFIR) filter configured to use the above-obtained mathematical expressions for $\beta_{tx}$, $\beta_{rx}$ in order to compensate the contributions 112 made by the TX 102 and the RX 104 in the combined TX/RX frequency-dependent I/Q imbalance.

According to FIG. 3, the communication apparatus 100 operates as follows. When it is required to estimate the combined TX/RX frequency-dependent I/Q imbalance (i.e. perform the steps S212-S216), the switch 310 is off, so that the AFIR filter 110 is used. When it is required to compensate the determined contributions 112 made by the TX 102 and the RX 104 in the combined TX/RX frequency-dependent I/Q imbalance (i.e. perform the step S218), the switch 310 is on, so that the pre-compensating FIR filter 312 is used. It should be noted that the "on" position of the switch 310 corresponds to the situation when the communication apparatus 100 is used for regular data transmission via the antenna 316. Irrespective of the position of the switch 310, the reference signal x(t) goes to the adder 314 where it is added with a predistortion signal pd(t) from the DSP unit 326 to reduce the nonlinearity distortions caused by the amplifier 308. The reference signal then goes from the adder 314 though the DAC 302 to the up-converter 304. The up-converter 304 performs the quadrature mixing of the reference signal with the TX LO signal generated by the PLL 106, thereby obtaining the TX RF signal. Further, the TX RF signal goes through the RF loopback path 108 to the RX 104.

More specifically, the RF loopback path 108 outputs the TX RF signal as the RX RF signal to the down-converter 318 in the RX 104. The down-converter 318 performs the quadrature mixing of the RX RF signal with the RX LO signal generated by the PLL 106, thereby obtaining the representation of the reference signal x(t), i.e. the reference signal x(t) with some signal errors caused by the combined TX/RX frequency-dependent I/Q imbalance. The representation of the reference signal then goes to the ADC 320. When the combined TX/RX frequency-dependent I/Q imbalance is estimated (i.e. the switch 310 is off), the switch 322 is off, so that an output signal of the ADC 320, which is denoted as $y\_fb(t)$ in FIG. 3, is aligned to the reference signal x($t$) (multiplied by a complex coefficient, which minimizes the squared error between the input samples of the reference signal x($t$) and the samples of the output signal $y\_fb(t)$). A specified error signal e($t$) is used in the DSP unit 326 to update a predistortion function by using the LMS or LS algorithm. The specified error signal $e(t)$ is also used to adapt coefficients of the AFIR filter 110 in the TX 102.

As noted earlier, the combined TX/RX frequency-dependent I/Q imbalance should be estimated twice for different phase shifts. The "phase shifter" is implemented by the phase shift between the TX LO signal and the RX LO signal. By using two AFIR impulse responses for the two phase shifts, the impulse responses of the pre-compensating FIR filter 312 in the TX 102 and the post-compensating FIR filter 321 in the RX 104 are calculated. Then, the contributions 112 made by the TX 102 and the RX 104 in the combined TX/RX frequency-dependent I/Q imbalance are compensated simultaneously, for which purpose the switches 310 and 324 should be both in the "on" position.

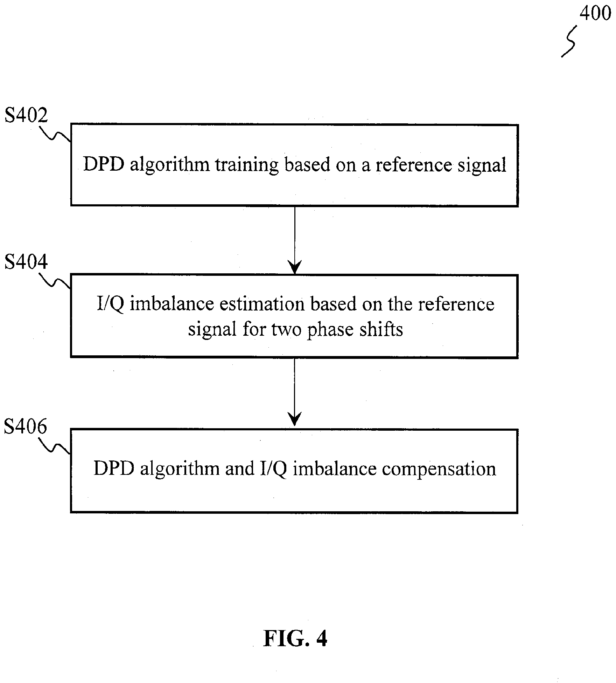

FIG. 4 shows a flowchart 400 explaining how the I/Q imbalance estimation and compensation may be used in concert with the DPD algorithm in the method 200 in accordance with one exemplary embodiment. The flowchart 400 starts with a step S402, in which the DPD algorithm is trained based on the reference signal to find an acceptable predistortion signal pd(t). Then, the flowchart 400 goes to a step S404, in which the combined TX/RX frequency-dependent I/Q imbalance is estimated twice at the first and second phase shifts, as discussed above (i.e. the steps S202-S216 are performed), and the resulting two estimates of the combined TX/RX frequency-dependent I/Q imbalance are used to calculate the impulse responses of the pre-compensating FIR filter 312 and the post-compensating FIR filter 324. After that, the flowchart 400 proceeds to a step S406, in which the DPD algorithm and the I/Q imbalance compensation (i.e. the step 5218 performed based on the calculated impulse responses of the FIR filters 312, 324) are used together.

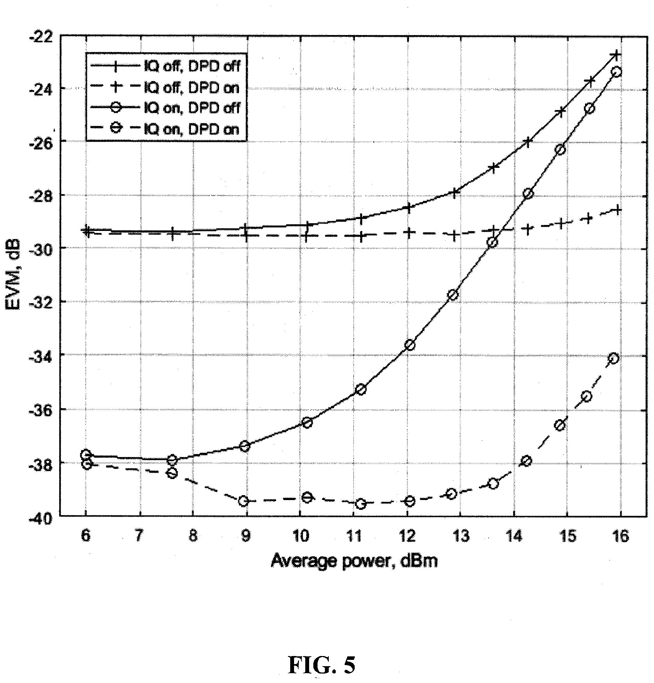

FIG. 5 shows dependences of an error value magnitude (EVM) on an average output power of the nonlinear power amplifier 308 included in the TX 102, which are obtained on a test platform by using the method 200 in view of the flowchart 400. In other words, the dependences show the results of the joint application of the I/Q imbalance estimation and compensation and the digital predistortion of the power amplifier nonlinearity. In FIG. 5, "IQ on/off" means that the method 200 is used/not used, and "DPD on/off" means that the DPD algorithm is used/not used. As can be seen, the best results, i.e. the largest reduction of the EVM, are achieved when the method 200 is used together with the DPD algorithm (see the dependence corresponding to "IQ on, DPD on" in FIG. 5). At the same time, the method 200, as used without the DPD algorithm, also allows significantly reducing the EVM.

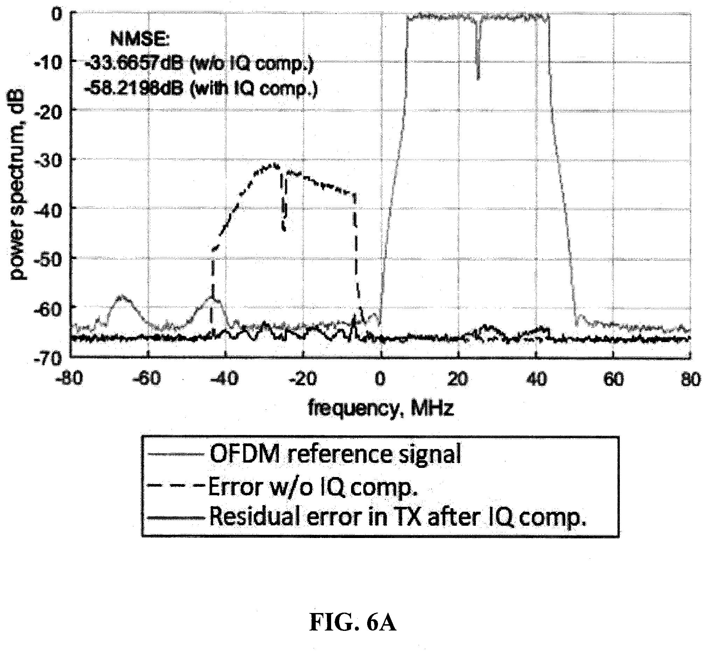

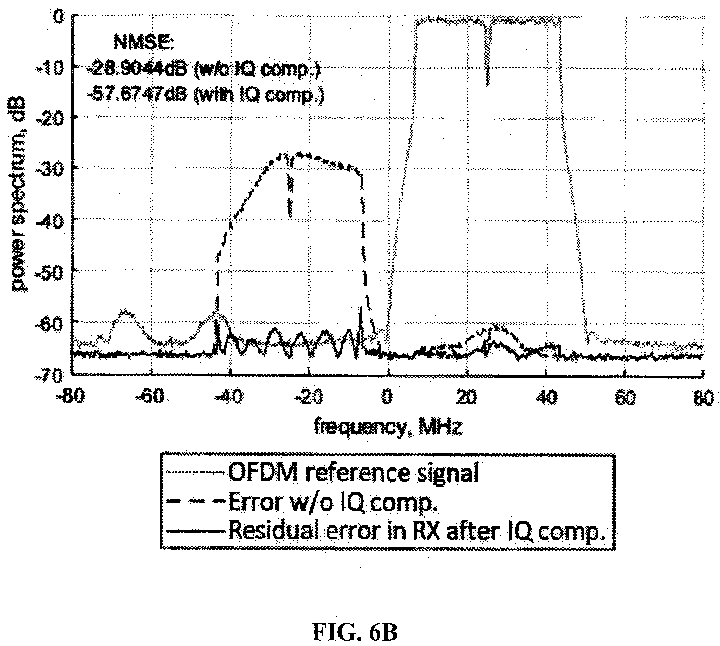

FIG. 6A and 6B show a power spectral density of a residual I/Q imbalance signal at the output of the TX 102 and the RX 104, respectively, which is resulted from the use of the method 200 without considering the nonlinearity of the power amplifier 308. To distinguish an I/Q imbalance signal caused by the I/Q imbalance source(s) provided in each of the TX 102 and the RX 104 from the reference signal represented by an OFDM signal, the reference signal is shifted in frequency to the region of positive frequencies. The I/Q imbalance signal is presented as a weighted complex conjugate of the reference signal. In this case, the complexconjugate signal is located in the region of negative frequencies. Thus, the reference signal (shown by using a gray solid line) and the I/Q imbalance signal (shown by using a black dashed line) are located in different frequency ranges. The residual I/Q imbalance signal obtained by using the method 200 is shown in FIG. 6A and 6B by using a black solid line. As can be seen, the method 200 almost eliminates the I/Q imbalance signal (see its normalized mean-square error (NMSE) values for cases with and without the I/Q imbalance compensation performed by using the method 200). It should be also noted that such estimates (i.e. NMSE values) cannot be obtained in the presence of the nonlinear power amplifier 308, since the nonlinear distortions caused by the power amplifier 308 do not allow the residual I/Q imbalance signal to be seen against their background (i.e. the error in the reference signal will be mostly determined by these nonlinear distortions).

It should be noted that one or more steps or operations of the method 200 and the flowchart 400 may be implemented by various means, such as hardware, firmware, and/or software. As an example, one or more of the steps or operations described above may be embodied by a computer code, processor executable instructions, data structures, program modules, and other suitable data representations. Furthermore, the computer code which embodies the step(s) or operation(s) described above may be stored on a corresponding data carrier and executed by at least one processor of a computing device. This data carrier may be implemented as any computer-readable storage medium configured to be readable by said at least one processor to execute the computer code. Such computer-readable storage media may include both volatile and nonvolatile media, removable and non-removable media. By way of example, and not limitation, the computer-readable media comprise media implemented in any method or technology suitable for storing information. In more detail, the practical examples of the computer-readable media include, but are not limited to information-delivery media, RAM, ROM, EEPROM, flash memory or other memory technology, CD-ROM, digital versatile discs (DVD), holographic media or other optical disc storage, magnetic tape, magnetic cassettes, magnetic disk storage, and other magnetic storage devices.

Although the exemplary embodiments of the present disclosure are described herein, it should be noted that the present invention is defined by the scope of the appended claims.

**Claims**

1.   A communication apparatus (100) comprising:

   a transmitter,TX (102);
   a receiver, RX (104); and
   a phase-locked loop (106) configured to:

      generate a TX local oscillator, LO, signal and a RX LO signal, and
      successively provide a first phase shift and a different second phase shift between the TX LO signal and the RX LO signal,

   wherein the TX is configured to:

      generate a reference signal, and
      obtain a TX radio frequency, RF, signal by quadrature mixing of the reference signal with the TX LO signal,

   wherein the communication apparatus (100) further comprises a RF loopback path (108) configured to output the TX RF signal to the RX as a RX RF signal,
   wherein the RX is configured to obtain a representation of the reference signal by quadrature mixing of the RX RF signal with the RX LO signal, and
   wherein the TX (102) comprises an adaptive filter (110) configured to:

      based on the reference signal and the representation of the reference signal in case of the first phase shift between the TX LO signal and the RX LO signal, obtain a first estimate of a combined TX/RX frequency-dependent In-phase and Quadrature, I/Q, imbalance in a time domain,
      based on the reference signal and the representation of the reference signal in case of the second phase shift between the TX LO signal and the RX LO signal, obtain a second estimate of the combined TX/RX frequency-dependent I/Q imbalance in the time domain, and
      based on the first and second estimates, determine a contribution made by each of the TX and the RX in the combined TX/RX frequency-dependent I/Q imbalance in the time domain.

2.   The communication apparatus of claim 1, wherein the TX is configured to generate the reference signal as a pseudo-noise signal or an Orthogonal Frequency-Division Multiplexing, OFDM, signal.

3.   The communication apparatus of claim 1 or 2, wherein the adaptive filter is configured to obtain the first estimate of the combined TX/RX frequency-dependent I/Q imbalance and the second estimate of the combined TX/RX frequency-dependent I/Q imbalance using one of a Least-Mean-Square, LMS, algorithm, a normalized LMS algorithm, a leaky LMS algorithm, and a recursive least square algorithm.

4.   The communication apparatus of any one of claims 1 to 3, wherein the second phase shift differs from the first phase shift by 90 degrees.

5.   The communication apparatus of any one of claims 1 to 4, wherein the TX further comprises a pre-compensating finite impulse response, FIR, filter configured to compensate the determined contribution made by the TX in the combined TX/RX frequency-dependent I/Q imbalance, and wherein the RX comprises a post-compensating FIR filter configured to compensate the determined contribution made by the RX in the combined TX/RX frequency-dependent I/Q imbalance.

6.  The communication apparatus of claim 5, wherein each of the pre-compensating FIR filter and the post-compensating FIR filter has a filter length predefined based on a required accuracy of I/Q imbalance contribution compensation and/or a required amount of computational resources to be used for the I/Q imbalance contribution compensation.

7.  The communication apparatus of claim 5 or 6, wherein the pre-compensating FIR filter and the post-compensating FIR filter are configured to simultaneously compensate the determined contributions made by the TX and the RX, respectively, in the combined TX/RX frequency-dependent I/Q imbalance.

8.  The communication apparatus of any one of claims 5 to 7, wherein the pre-compensating FIR filter and the post-compensating FIR filter are configured to compensate the determined contributions made by the TX and the RX, respectively, in the combined TX/RX frequency-dependent I/Q imbalance when the communication apparatus operates in a time division duplexing mode.

9.  The communication apparatus of any one of claims 1 to 8, wherein the TX further comprises a nonlinear power amplifier configured to amplify the TX RF signal, and wherein the communication apparatus further comprises a digital signal processing unit configured to reduce nonlinear distortions occurring in the amplified TX RF signal by using a digital pre-distortion algorithm.

10. A method (200) for In-phase and Quadrature, I/Q, imbalance estimation in a communication apparatus, the communication apparatus comprising a transmitter, TX, a receiver, RX, a phase-locked loop, PLL, and a radio frequency, RF, loopback path connecting the TX and the RX, wherein the method comprises:

   (a) generating (S202), by the TX, a reference signal;
   (b) generating (S204), by the PLL, a TX local oscillator, LO, signal and a RX LO signal;
   (c) obtaining (S206), by the TX, a TX radio frequency, RF, signal by quadrature mixing of the reference signal with the TX LO signal;
   (d) outputting (S208) the TX RF signal to the RX as a RX RF signal through the RF loopback path; and
   (e) obtaining (S210), by the RX, a representation of the reference signal by quadrature mixing the RX RF signal with the RX LO signal,
   wherein steps (a)-(e) are performed successively at a first phase shift and a different second phase shift between the TX LO signal and the RX LO signal, and
   wherein the method further comprises:

   (f) based on the reference signal and the representation of the reference signal in case of the first phase shift between the TX LO signal and the RX LO signal, obtaining (S212) a first estimate of a combined TX/RX frequency-dependent I/Q imbalance in a time domain;
   (g) based on the reference signal and the representation of the reference signal in case of the second phase shift between the TX LO signal and the RX LO signal, obtaining (S214) a second estimate of the combined TX/RX frequency-dependent I/Q imbalance in the time domain; and
   (h) based on the first and second estimates, determining (S216) a contribution made by each of the TX and the RX in the combined TX/RX frequency-dependent I/Q imbalance in the time domain.

11. The method of claim 10, wherein step (a) comprises generating the reference signal as a pseudo-noise signal or an Orthogonal Frequency-Division Multiplexing (OFDM) signal.

12. The method of claim 10 or 11, wherein steps (f) and (g) are performed using one of a Least-Mean-Square (LMS) algorithm, a normalized LMS algorithm, a leaky LMS algorithm, and a recursive least square algorithm.

13. The method of any one of claims 10 to 12, wherein the second phase shift differs from the first phase shift by 90 degrees.

14. The method of any one of claims 10 to 13, further comprising compensating the determined contribution made by each of the TX and the RX in the combined TX/RX frequency-dependent I/Q imbalance using a pre-compensating finite impulse response, FIR, filter in the TX and a post-compensating FIR filter in the RX, each of the pre-compensating FIR filter and the post-compensating FIR filter having a filter length predefined based on a required accuracy of I/Q imbalance contribution compensation and/or a required amount of computational resources to be used for the I/Q imbalance contribution compensation.

15. The method of claim 14, wherein the determined contributions made by the TX and the RX in the combined TX/RX frequency-dependent I/Q imbalance are compensated simultaneously.

16. The method of claim 14 or 15, wherein the determined contributions made by the TX and the RX in the combined TX/RX frequency-dependent I/Q imbalance are compensated when the communication apparatus operates in a time division duplexing mode.

17. The method of any one of claims 10 to 16, further comprising:

amplifying the TX RF signal using a nonlinear power amplifier in the TX; and
reducing nonlinear distortions occurring in the amplified TX RF signal using a digital pre-distortion algorithm.

18. A computer program product comprising a computer-readable storage medium, wherein the computer-readable storage medium comprises a computer code which, when executed by at least one processor of a communication apparatus, causes the communication apparatus to perform the method according to any one of claims 10 to 17.

**Patentansprüche**

1. Kommunikationsvorrichtung (100), umfassend:

einen Sender, TX (102);
einen Empfänger, RX (104); und
eine Phasenregelschleife (106), die zu Folgendem konfiguriert ist:

Erzeugen eines TX-Lokaloszillatorsignals, TX-LO-Signals, und eines RX-LO-Signals und aufeinanderfolgendes Bereitstellen einer ersten Phasenverschiebung und einer anderen zweiten Phasenverschiebung zwischen dem TX-LO-Signal und dem RX-LO-Signal,
wobei der TX zu Folgendem konfiguriert ist:

Erzeugen eines Referenzsignals und
Erlangen eines TX-Funkfrequenzsignals, TX-RF-Signals, durch Quadraturmischung des Referenzsignals mit dem TX-LO-Signal,
wobei die Kommunikationsvorrichtung (100) ferner einen RF-Loopback-Pfad (108) umfasst, der dazu konfiguriert ist, das TX-RF-Signal an den RX als RX-RF-Signal auszugeben,
wobei der RX dazu konfiguriert ist, eine Darstellung des Referenzsignals durch Quadraturmischung des RX-RF-Signals mit dem RX-LO-Signal zu erlangen, und
wobei der TX (102) ein adaptives Filter (110) umfasst, das zu Folgendem konfiguriert ist:

basierend auf dem Referenzsignal und der Darstellung des Referenzsignals im Fall der ersten Phasenverschiebung zwischen dem TX-LO-Signal und dem RX-LO-Signal, Erlangen einer ersten Schätzung eines kombinierten TX/RX-frequenzabhängigen In-Phaseund Quadratur-Ungleichgewichts, I/Q-Ungleichgewichts, in einem Zeitbereich,
basierend auf dem Referenzsignal und der Darstellung des Referenzsignals im Fall der zweiten Phasenverschiebung zwischen dem TX-LO-Signal und dem RX-LO-Signal, Erlangen einer zweiten Schätzung des kombinierten TX/RX-frequenzabhängigen I/Q-Ungleichgewichts in dem Zeitbereich und
basierend auf der ersten und der zweiten Schätzung, Bestimmen eines Beitrags, den jeder von dem TX und dem RX zu dem kombinierten TX/RX-frequenzabhängigen I/Q-Ungleichgewicht in dem Zeitbereich leistet.

2. Kommunikationsvorrichtung nach Anspruch 1, wobei der TX dazu konfiguriert ist, das Referenzsignal als ein Pseudo-Rauschsignal oder ein Orthogonal-Frequency-Division-Multiplexing-Signal, OFDM-Signal, zu erzeugen.

3. Kommunikationsvorrichtung nach Anspruch 1 oder 2, wobei das adaptive Filter dazu konfiguriert ist, die erste Schätzung des kombinierten TX/RX-frequenzabhängigen I/Q-Ungleichgewichts und die zweite Schätzung des kombinierten TX/RX-frequenzabhängigen I/Q-Ungleichgewichts unter Verwendung eines Least-Mean-Square-Algorithmus, LMS-Algorithmus, eines normalisierten LMS-Algorithmus, eines Leaky-LMS-Algorithmus und eines rekursiven Least-Square-Algorithmus zu erlangen.

4. Kommunikationsvorrichtung nach einem der Ansprüche 1 bis 3, wobei sich die zweite Phasenverschiebung um 90 Grad von der ersten Phasenverschiebung unterscheidet.

5. Kommunikationsvorrichtung nach einem der Ansprüche 1 bis 4, wobei der TX ferner ein vorkompensierendes Finite-Impulse-Response-Filter, FIR-Filter, umfasst, das dazu konfiguriert ist, den bestimmten Beitrag, den der TX zu dem kombinierten TX/RXfrequenzabhängigen I/Q-Ungleichgewicht leistet, zu kompensieren, und wobei der RX ein nachkompensierendes FIR-Filter umfasst, das dazu konfiguriert ist, den bestimmten Beitrag, den der RX zu dem kombinierten TX/RX-frequenzabhängigen I/Q-Ungleichgewicht leistet, zu kompensieren.

6. Kommunikationsvorrichtung nach Anspruch 5, wobei jedes von dem vorkompensierenden FIR-Filter und dem nachkompensierenden FIR-Filter eine Filterlänge aufweist, die basierend auf einer erforderlichen Genauigkeit der I/Q-Ungleichgewichtsbeitragskompensation und/oder einer erforderlichen Menge an Rechenressourcen, die für die I/Q-Ungleichgewichtsbeitragskompensation zu verwenden sind, vordefiniert ist.

7. Kommunikationsvorrichtung nach Anspruch 5 oder 6, wobei das vorkompensierende FIR-Filter und das nachkompensierende FIR-Filter dazu konfiguriert sind, die bestimmten Beiträge, die der TX und der RX jeweils zu dem kombinierten TX/RXfrequenzabhängigen I/Q-Ungleichgewicht leisten, gleichzeitig zu kompensieren.

8. Kommunikationsvorrichtung nach einem der Ansprüche 5 bis 7, wobei das vorkompensierende FIR-Filter und das nachkompensierende FIR-Filter dazu konfiguriert sind, die bestimmten Beiträge, die der TX und der RX jeweils zu dem kombinierten TX/RX-frequenzabhängigen I/Q-Ungleichgewicht leisten, zu kompensieren, wenn die Kommunikationsvorrichtung in einem Zeitduplexmodus arbeitet.

9. Kommunikationsvorrichtung nach einem der Ansprüche 1 bis 8, wobei der TX ferner einen nichtlinearen Leistungsverstärker umfasst, der dazu konfiguriert ist, das TX-RF-Signal zu verstärken, und wobei die Kommunikationsvorrichtung ferner eine digitale Signalverarbeitungseinheit umfasst, die dazu konfiguriert ist, nichtlineare Verzerrungen, die im verstärkten TX-RF-Signal auftreten, durch Verwendung eines digitalen Vorverzerrungsalgorithmus zu verringern.

10. Verfahren (200) zur Schätzung von In-Phase- und Quadratur-Ungleichgewichten, I/Q-Ungleichgewichten, in einer Kommunikationsvorrichtung, wobei die Kommunikationsvorrichtung einen Sender, TX, einen Empfänger, RX, eine Phasenregelschleife, PLL, und einen Radiofrequenz-Loopback-Pfad, RF-Loopback-Pfad, umfasst, der den TX und den RX verbindet, wobei das Verfahren Folgendes umfasst:

(a) Erzeugen (S202), durch den TX, eines Referenzsignals;
(b) Erzeugen (S204), durch die PLL, eines TX-LokaloszillatorSignals, TX-LO-Signals, und eines RX-LO-Signals;
(c) Erlangen (S206), durch den TX, eines TX-Funkfrequenzsignals, TX-RF-Signals, durch Quadraturmischung des Referenzsignals mit dem TX-LO-Signal;
(d) Ausgeben (S208) des TX-RF-Signals an den RX als ein RX-RF-Signal über den RF-Loopback-Pfad; und
(e) Erlangen (S210), durch den RX, einer Darstellung des Referenzsignals durch Quadraturmischung des RX-RF-Signals mit dem RX-LO-Signal,
wobei Schritte (a)-(e) aufeinanderfolgend bei einer ersten Phasenverschiebung und einer anderen zweiten Phasenverschiebung zwischen dem TX-LO-Signal und dem RX-LO-Signal durchgeführt werden, und
wobei das Verfahren ferner Folgendes umfasst:

(f) basierend auf dem Referenzsignal und der Darstellung des Referenzsignals im Fall der ersten Phasenverschiebung zwischen dem TX-LO-Signal und dem RX-LO-Signal, Erlangen (S212) einer ersten Schätzung eines kombinierten TX/RX-frequenzabhängigen I/Q-Ungleichgewichts in einem Zeitbereich;
(g) basierend auf dem Referenzsignal und der Darstellung des Referenzsignals im Fall der zweiten Phasenverschiebung zwischen dem TX-LO-Signal und dem RX-LO-Signal, Erlangen (S214) einer zweiten Schätzung des kombinierten TX/RX-frequenzabhängigen I/Q-Ungleichgewichts in dem Zeitbereich; und
(h) basierend auf der ersten und der zweiten Schätzung, Bestimmen (S216) eines Beitrags, den jeder von dem TX und dem RX zu dem kombinierten TX/RX-frequenzabhängigen I/Q-Ungleichgewicht in dem Zeitbereich leistet.

11. Verfahren nach Anspruch 10, wobei der Schritt (a) Erzeugen des Referenzsignals als ein Pseudo-Rauschsignal oder ein Orthogonal-Frequency-Division-Multiplexing-Signal, OFDM-Signal, umfasst.

12. Verfahren nach Anspruch 10 oder 11, wobei die Schritte (f) und (g) unter Verwendung eines Least-Mean-Square-Algorithmus, LMS-Algorithmus, eines normalisierten LMS-Algorithmus, eines Leaky-LMS-Algorithmus und eines rekursiven Least-Square-Algorithmus durchgeführt werden.

13. Verfahren nach einem der Ansprüche 10 bis 12, wobei sich die zweite Phasenverschiebung um 90 Grad von der ersten Phasenverschiebung unterscheidet.

14. Verfahren nach einem der Ansprüche 10 bis 13, ferner umfassend Kompensieren des bestimmten Beitrags, den jeder von dem TX und dem RX zu dem kombinierten TX/RX-frequenzabhängigen I/Q-Ungleichgewicht leistet, unter Verwendung eines vorkompensierenden Finite-Impulse-Response-Filters, FIR-Filters, im TX und eines nachkompensierenden FIR-Filters im RX, wobei jedes von dem vorkompensierenden FIR-Filter und dem nachkompensierenden FIR-Filter eine Filterlänge aufweist, die basierend auf einer erforderlichen Genauigkeit der I/Q-Ungleichgewichtsbeitragskompensation und/oder einer erforderlichen Menge an Rechenressourcen, die für die I/Q-Ungleichgewichtsbeitragskompensation zu verwenden sind, vordefiniert ist.

15. Verfahren nach Anspruch 14, wobei die bestimmten Beiträge, die der TX und der RX zu dem kombinierten TX/RXfrequenzabhängigen I/Q-Ungleichgewicht leisten, gleichzeitig kompensiert werden.

16. Verfahren nach Anspruch 14 oder 15, wobei die bestimmten Beiträge, die der TX und der RX zu dem kombinierten TX/RXfrequenzabhängigen I/Q-Ungleichgewicht leisten, kompensiert werden, wenn die Kommunikationsvorrichtung in einem Zeitduplexmodus arbeitet.

17. Verfahren nach einem der Ansprüche 10 bis 16, ferner umfassend:

Verstärken des TX-RF-Signals unter Verwendung eines nichtlinearen Leistungsverstärkers im TX; und
Verringern nichtlinearer Verzerrungen, die im verstärkten TX-RF-Signal auftreten, unter Verwendung eines digitalen Vorverzerrungsalgorithmus.

18. Computerprogrammprodukt, umfassend ein computerlesbares Speichermedium, wobei das computerlesbare Speichermedium einen Computercode umfasst, der, wenn er von mindestens einem Prozessor einer Kommunikationsvorrichtung ausgeführt wird, die Kommunikationsvorrichtung dazu veranlasst, das Verfahren nach einem der Ansprüche 10 bis 17 durchzuführen.

**Revendications**

1. Appareil de communication (100), comprenant :

un émetteur, TX (102) ;
un récepteur, RX (104) ; et
une boucle à verrouillage de phase (106) configurée pour :

générer un signal d'oscillateur local, LO, TX et un signal LO RX, et
fournir successivement un premier déphasage et un second déphasage différent entre le signal LO TX et le signal LO RX,
dans lequel le TX est configuré pour :

générer un signal de référence, et
obtenir un signal radiofréquence RF, TX, par mélange en quadrature du signal de référence avec le signal LO TX,
dans lequel l'appareil de communication (100) comprend en outre un chemin de bouclage RF (108) configuré pour émettre le signal RF TX vers le RX sous la forme d'un signal RF RX,

dans lequel le RX est configuré pour obtenir une représentation du signal de référence par mélange en quadrature du signal RF RX avec le signal LO RX, et

dans lequel le TX (102) comprend un filtre adaptatif (110) configuré pour :

sur la base du signal de référence et de la représentation du signal de référence dans le cas du premier déphasage entre le signal LO TX et le signal LO RX, obtenir une première estimation d'un déséquilibre en phase et en quadrature, I/Q, dépendant de la fréquence TX/RX combinée, dans un domaine temporel,

sur la base du signal de référence et de la représentation du signal de référence dans le cas du second déphasage entre le signal LO TX et le signal LO RX, obtenir une seconde estimation du déséquilibre I/Q dépendant de la fréquence TX/RX combinée, dans le domaine temporel, et

sur la base des première et seconde estimation, déterminer une contribution apportée par chacun du TX et du RX au déséquilibre I/Q dépendant de la fréquence TX/RX combinée dans le domaine temporel.

2. Appareil de communication selon la revendication 1, dans lequel le TX est configuré pour générer le signal de référence sous la forme d'un signal de pseudo-bruit ou d'un signal de multiplexage par répartition orthogonale de la fréquence, OFDM.

3. Appareil de communication selon la revendication 1 ou 2, dans lequel le filtre adaptatif est configuré pour obtenir la première estimation du déséquilibre I/Q dépendant de la fréquence TX/RX combinée et la seconde estimation du déséquilibre I/Q dépendant de la fréquence TX/RX combinée à l'aide d'un algorithme des moindres carrés moyens, LMS, d'un algorithme LMS normalisé, d'un algorithme LMS à fuite et d'un algorithme des moindres carrés récursifs.

4. Appareil de communication selon l'une quelconque des revendications 1 à 3, dans lequel le second déphasage diffère du premier déphasage de 90 degrés.

5. Appareil de communication selon l'une quelconque des revendications 1 à 4, dans lequel le TX comprend en outre un filtre à réponse impulsionnelle finie de pré-compensation, FIR, configuré pour compenser la contribution déterminée apportée par le TX dans le déséquilibre I/Q dépendant de la fréquence TX/RX combinée, et dans lequel le RX comprend un filtre FIR de post-compensation configuré pour compenser la contribution déterminée apportée par le RX au déséquilibre I/Q dépendant de la fréquence TX/RX combinée.

6. Appareil de communication selon la revendication 5, dans lequel chacun du filtre FIR de pré-compensation et du filtre FIR de post-compensation a une longueur de filtre prédéfinie sur la base d'une précision requise de compensation de contribution de déséquilibre I/Q et/ou d'une quantité requise de calcul de ressources à utiliser pour la compensation de la contribution au déséquilibre I/Q.

7. Appareil de communication selon la revendication 5 ou 6, dans lequel le filtre FIR de pré-compensation et le filtre FIR de post-compensation sont configurés pour compenser simultanément les contributions déterminées apportées par le TX et le RX, respectivement, dans le déséquilibre I/Q dépendant de la fréquence TX/RX combinée.

8. Appareil de communication selon l'une quelconque des revendications 5 à 7, dans lequel le filtre FIR de pré-compensation et le filtre FIR de post-compensation sont configurés pour compenser les contributions déterminées apportées par le TX et le RX, respectivement, dans le déséquilibre I/Q dépendant de la fréquence TX/RX combinée lorsque l'appareil de communication fonctionne dans un mode de duplexage temporel.

9. Appareil de communication selon l'une quelconque des revendications 1 à 8, dans lequel le TX comprend en outre un amplificateur de puissance non linéaire configuré pour amplifier le signal RF TX, et dans lequel l'appareil de communication comprend en outre une unité de traitement de signal numérique configurée pour réduire les distorsions non linéaires se produisant dans le signal RF TX amplifié en utilisant un algorithme de pré-distorsion numérique.

10. Procédé (200) d'estimation de déséquilibre en phase et en quadrature, I/Q, dans un appareil de communication, l'appareil de communication comprenant un émetteur, TX, un récepteur, RX, une boucle à verrouillage de phase, PLL, et chemin de bouclage de radiofréquence, RF, reliant le TX et le RX, dans lequel le procédé comprend :

(a) la génération (S202), par le TX, d'un signal de référence ;

(b) la génération (S204), par la PLL, d'un signal d'oscillateur local, LO, TX, et d'un signal LO RX ;

(c) l'obtention (S206), par le TX, d'un signal radiofréquence, RF, TX, par mélange en quadrature du signal de référence avec le signal LO TX ;

(d) l'émission (S208) du signal RF TX vers le RX sous la forme d'un signal RF RX via le chemin de bouclage RF ; et

(e) l'obtention (S210), par le RX, d'une représentation du signal de référence par mélange en quadrature du signal RF RX avec le signal LO RX,

dans lequel les étapes (a) à (e) sont effectuées successivement à un premier déphasage et à un second déphasage différent entre le signal LO TX et le signal LO RX, et

dans lequel le procédé comprend en outre :

(f) sur la base du signal de référence et de la représentation du signal de référence dans le cas du premier déphasage entre le signal LO TX et le signal LO RX, l'obtention (S212) d'une première estimation d'un déséquilibre en phase et en quadrature I/Q dépendant de la fréquence TX/RX combinée dans un domaine temporel ;

(g) sur la base du signal de référence et de la représentation du signal de référence dans le cas du second déphasage entre le signal LO TX et le signal LO RX, l'obtention (S214) d'une seconde estimation du déséquilibre I/Q dépendant de la fréquence TX/RX combinée dans le domaine temporel, et

(h) sur la base des première et seconde estimations, la détermination (S216) d'une contribution apportée par chacun du TX et du RX au déséquilibre I/Q dépendant de la fréquence TX/RX combinée dans le domaine temporel.

11. Procédé selon la revendication 10, dans lequel l'étape (a) comprend la génération du signal de référence sous la forme d'un signal de pseudo-bruit ou d'un signal de multiplexage par répartition orthogonale de la fréquence (OFDM).

12. Procédé selon la revendication 10 ou 11, dans lequel les étapes (f) et (g) sont effectuées en utilisant l'un parmi un algorithme des moindres carrés moyens (LMS), un algorithme LMS normalisé, un algorithme LMS à fuite et un algorithme des moindres carrés récursifs.

13. Procédé selon l'une quelconque des revendications 10 à 12, dans lequel le second déphasage diffère du premier déphasage de 90 degrés.

14. Procédé selon l'une quelconque des revendications 10 à 13, comprenant en outre la compensation de la contribution déterminée apportée par chacun des TX et RX dans le déséquilibre I/Q dépendant de la fréquence TX/RX combinée en utilisant un filtre de réponse impulsionnelle finie de pré-compensation, FIR, dans le TX et un filtre FIR de post-compensation dans le RX, chacun du filtre FIR de pré-compensation et du filtre FIR de post-compensation ayant une longueur de filtre prédéfinie sur la base d'une précision requise de compensation de contribution de déséquilibre I/Q et/ou une quantité requise de ressources de calcul à utiliser pour la compensation de contribution au déséquilibre I/Q.

15. Procédé selon la revendication 14, dans lequel les contributions déterminées apportées par le TX et le RX dans le déséquilibre I/Q dépendant de la fréquence TX/RX combinée sont compensées simultanément.

16. Procédé selon la revendication 14 ou 15, dans lequel les contributions déterminées apportées par le TX et le RX dans le déséquilibre I/Q dépendant de la fréquence TX/RX combinée sont compensées lorsque l'appareil de communication fonctionne dans un mode de duplexage par répartition dans le temps.

17. Procédé selon l'une quelconque des revendications 10 à 16, comprenant en outre :

l'amplification du signal RF TX à l'aide d'un amplificateur de puissance non linéaire dans le TX ; et
la réduction de distorsions non linéaires se produisant dans le signal RF TX amplifié à l'aide d'un algorithme de pré-distorsion numérique.

18. Produit de programme informatique comprenant un support de stockage lisible par ordinateur, dans lequel le support de stockage lisible par ordinateur comprend un code informatique qui, lorsqu'il est exécuté par au moins un processeur d'un appareil de communication, amène l'appareil de communication à mettre en oeuvre le procédé selon l'une quelconque des revendications 10 à 17.

**FIG. 1**

$\overset{200}{\underset{\zeta}{\diagup}}$

| S202 | | S204 | | S206 | | S208 | | S210 |
|---|---|---|---|---|---|---|---|---|
| Generating, by a TX, a reference signal | → | Generating, by a PLL, a TX LO signal and a RX LO signal | → | Obtaining, by the TX, a TX RF signal by quadrature mixing of a reference signal with the TX LO signal | → | Outputting the TX RF signal to the RX through a RF loopback path | → | Obtaining, by the RX, a representation of the reference signal by quadrature mixing the RX RF signal with the RX LO signal |

*Performing successively at first and second phase shifts between the TX LO signal and the RX LO signal*

| S218 | | S216 | | S214 | | S212 |
|---|---|---|---|---|---|---|
| Compensating the determined contributions | ← | Determining a contribution made by each of the TX and the RX into the combined TX/RX frequency-dependent I/Q imbalance in the time domain | ← | Obtaining a second estimate of the combined TX/RX frequency-dependent I/Q imbalance in the time domain | ← | Obtaining a first estimate of a combined TX/RX frequency-dependent I/Q imbalance in a time domain |

**FIG. 2**

FIG. 3

EP 4 248 604 B1

S402

DPD algorithm training based on a reference signal

S404

I/Q imbalance estimation based on the reference
signal for two phase shifts

S406

DPD algorithm and I/Q imbalance compensation

400

**FIG. 4**

FIG. 5

FIG. 6A

FIG. 6B

**REFERENCES CITED IN THE DESCRIPTION**

**Patent documents cited in the description**

- US 2016359614 A1